(19) Europäisches Patentamt
European Patent Office
Office européen des brevets

(11) Publication number: **0 284 314**
**A1**

(12) **EUROPEAN PATENT APPLICATION**

(21) Application number: **88302424.2**

(22) Date of filing: **18.03.88**

(51) Int. Cl.[4]: **H01L 29/28**, C08J 5/18, B05D 1/36

(30) Priority: **25.03.87 FI 871320**

(43) Date of publication of application: **28.09.88 Bulletin 88/39**

(84) Designated Contracting States: **AT BE CH DE ES FR GB GR IT LI LU NL SE**

(71) Applicant: **K & V LICENCING OY**
**Höyläämötie 11**
**SF-00380 Helsinki(FI)**

(72) Inventor: **Virtanen, Jorma**
**Ristiaallonkatu 4 C 71**
**SF-02320 Espoo(FI)**
Inventor: **Kuio, Arvo**
**Iskostie 2 D 35**
**SF-01600 Vantaa(FI)**
Inventor: **Patrikainen, Jari**
**Kurkiaispolku 3 J 54**
**SF-00940 Helsinki(FI)**
Inventor: **Kinnunen, Paavo**
**Punarinnantie 4**
**SF-02660 Espoo(FI)**

(74) Representative: **Newell, William Joseph et al**
**D. Young & Co., 10 Staple Inn**
**London WC1V 7RD(GB)**

(54) **Langmuir-blodgett film aggregates.**

(57) A multilayered Langmuir-Blodgett film aggregate, which contains on top of a solid support surface several monomolecular layers of a compound of liquid crystal type preferably having the general formula

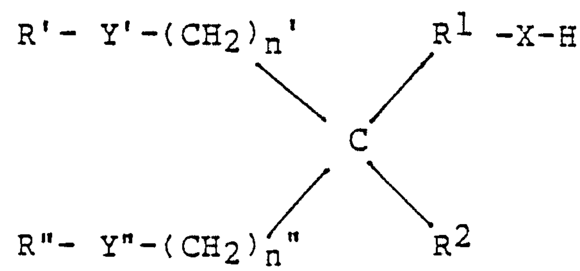

(I)

wherein R′ and R″ independently refer to a substantially aliphatic hydrocarbon group of approximately 8 to 30 carbon atoms, Y′ and Y″ independently refer to the group -O-, -C(=O)-O-, which over the oxygen atom is bound to the group $-(CH_2)_n-$or they refer to $-CH_2-$, n′ and n″ independently are zero or 1, $R^1$-X-H is a polar group wherein XH refers to hydroxy (OH), carboxyl (COOH), amino ($NH_2$), or an amino group substituted with a substantially aliphatic hydrocarbon group of not more than 30 carbon atoms, and $R^1$ is a direct bond, a carbonyl group -C(=O)-, lower alkylene or lower alkylene carboxyl lower alkylene, $R^2$ is hydrogen, lower

EP 0 284 314 A1

alkyl or lower alkoxycarbonyl or has the meaning of $R'$-X-H. or the meaning of $R'$-$Y'$-$(CH_2)_n$-. provided that the compound (I) does not contain more than three lipophilic groups as defined.

# Langmuir-Blodgett film aggregates

The present invention concerns a type of multilayered Langmuir-Blodgett film aggregates.

The manufacture of Langmuir-Blodgett films (LB-films), for example from glycerophospholipids or arachidic acid is prior known. The conventional glycerophospholipids have the advantage that they form well single-layered, i.e. monomolecular films, for example on a water surface. Also their compression isotherm which is an indication of their stiffness, is good with respect to film preparation, because a glycerophospholipid film of this type is reversibly "fluid" or flexible. When transferring a glycerophospholipid film onto a solid support surface, the molecular layer forming the first layer of a multilayered LB-film is transferred as a whole, its transfer ratio being thus almost 1. However, the deposition of the subsequent layers onto the support surface when preparing multilayered films does not succeed at all as well. The poor layer-forming properties are due to the ionic polar head, the hydrate shell of which prevents the films from adhering to each other.

Many classical LB-compounds on the other hand form easily multilayer films. Arachidic acid, for example, forms layers well, its transfer ratio being for all the layers almost 1. However, its film forming characteristics, for example on a water surface, are not at all as good as those of glycerophospholipids, the film being substantially more rigid.

According to the invention it has been discovered that compounds of liquid crystal type, which combine the good properties of the phospholipids and arachidic acid prior used for the preparation of LB-films, i.e. the liquid crystal properties of the lipophilic part and the hydrogen binding properties of the polar part, are very well suited for the preparation of multilayered LB-films. These compounds are designed to conform to all the requirements of the LB-technique: stability and structural order of the single layer film, easy transfer of the film to a support surface whereby the desired function is obtained in a predictable manner in the final multilayer film. Thus they exhibit both a satisfactory compression isotherm indicative of their film forming properties, as well as a good transfer ratio also when transferring the layers subsequent to the first layer onto the support surface. From these new compounds it is thus possible to manufacture LB-multilayer films of good quality onto support surfaces.

The compounds used according to the invention are generally characterized by 2 or 3 non-polar, long-chained, substantially aliphatic hydrocarbon groups which are optionally substituted as mentioned below, as well as at least one polar group capable of forming hydrogen bonds, the group being a hydroxy, amino, carboxy, or an amino group substituted with a substantially aliphatic hydrocarbon group, and in addition they may optionally contain a lower alkyl or lower alkoxy carbonyl group.

The compounds to be used according to the invention correspond to the general formula

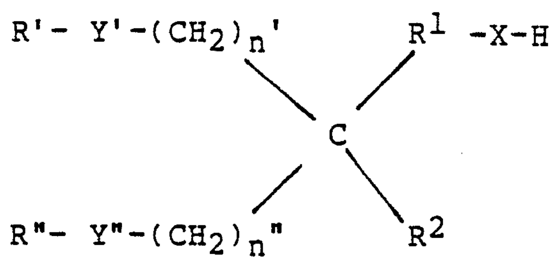

(I)

wherein R′ and R″ independently refer to a substantially aliphatic hydrocarbon group of approximately 8 to 30 carbon atoms, Y′ and Y″ independently refer to the group -O-, -C(=O)-O-, which over the oxygen atom is bound to the group $-(CH_2)_n$-or they refer to $-CH_2-$, n′ and n″ independently are zero or 1, $R^1$-X-H is a polar group wherein XH refers to hydroxy (OH), carboxyl (COOH), amino ($NH_2$), or an amino group substituted with a substantially aliphatic hydrocarbon group of not more than 30 carbon atoms, and $R^1$ is a direct bond, a carbonyl group -C(=O)-, lower alkylene or lower alkylene carboxyl lower alkylene, $R^2$ is hydrogen, lower alkyl or lower alkoxycarbonyl or has the meaning of $R^1$-X-H, or the meaning of $R'-Y'-(CH_2)_{n'}-$, provided that the compound (I) does not contain more than three lipophilic groups as defined.

The term "substantially aliphatic hydrocarbon group" refers to a saturated or unsaturated straight or branched hydrocarbon group which as a heteroatom may contain oxygen, nitrogen or sulphur, or as a part of the chain may contain covalently bound groups imparting the desired properties to the film, provided that the substantially aliphatic nature and the film forming properties of the compound do not thereby change.

The chains may similarly contain for example groups which polymerize with for example an adjacent side chain or with the support surface, such as double or triple bonds, or diazo groups bound to a benzene group.

The terms "long-chained" or "lipophilic" when used together with a substantially aliphatic hydrocarbon chain refers generally to a hydrocarbon chain of at least 8 carbon atoms. The term "lower" in connection with the substituents as defined, means that the said group contains 1 to 7, but preferably 1 to 4 carbon atoms.

The groups R′ and R″ contain generally from about 8 to 30 carbon atoms, preferably 12 to 20 carbon atoms. In the substituted amino group (-XH = -NRH) the length and nature of the substituent R depends on the desired properties in the finished film. If strong hydrogen bonding properties are desired between adjacent film layers, then a lower alkyl group is chosen as the substituent R. If, on the other hand, polymerizing properties are desired, then a chain of longer length and containing the desired polymerizing groups may be chosen. Such groups have the added advantage of being easily introduced into the amino group, thus providing for easy manufacture of compounds with specific characteristics. A long-chained substituent on the amino group may also serve as a "filler" in the film e.g. in cases where the group R′ or R″ contains a voluminous group, such as a pyrene group, as is described in more detail below.

The multilayered films made from the compounds of the formula I may be used as such, for example as resistive layers in various electronic applications, whereby they may contain fluorine and silicon containing organic groups.

Depending on the intended use of the multilayered films the long-chained non-polar hydrocarbon groups may also contain covalently bound as a part of the chain groups imparting desired electrical or optical properties to the film. The films made may, depending on the nature of these specific groups, be used for example in such electronical, electrical, electrochemical or photochemical applications, wherein use may be made of the active groups and of the changes brought about in their energy state, for example by means of external stimulation, such as by using light, for example optical or electrical changes. As examples photocells, sensors, indicators, microcircuits and computer memories may be mentioned. The structures may be used also in litographic processes in microelectronics when specific properties are desired from the sensitizing compounds used.

Among said active groups may be mentioned as groups participating in charge transfer, for example, mono-or polycyclic aromatic groups, such as phenyl, naphtyl, anthryl, phenantryl or more complicated aromatic systems, such as pyrene, perylene or triphenylene. In order to improve the electrical properties of the groups they may contain suitable substitutents, such as alkyl (preferably 1 to 3 C-atoms), alkoxy (preferably 1 to 3 C-atoms), cyano, hydroxy, oxo, amino, substituted amino, for example lower alkyl amino, thioether groups etc.

As photochromic groups e.g. the merocyanine, salicylaldoxime groups, azobenzene, cinnamic acid may be mentioned, which are suitable in applications wherein, for example, light is used as the external stimulus, e.g. for the manufacture of optical memories.

As suitable heterocyclic groups the polycyclic aromatic groups may be mentioned which are suitable for example in applications wherein sensitizers are required, which subsequent to absorbing a light quantum transfer it to an acceptor.

As groups suitable for the preparation of conducting films may be mentioned carbazole, quinone, hydroquinone, anthraquinone, TCNQ, tetrathiofulvalens and analogues.

The group covalently bound to the side chain may be located at any position in the chain, but for reason of easy manufacture it is preferably in the end position.

The afore mentioned substituted compounds of liquid crystal type may also be used for the preparation of films having a high degree of symmetry, so called super lattices, by using the method disclosed in our co-pending European Application No. 883 , filed concurrently herewith, our reference E187′8.

The compounds according to the invention are in part new and in part prior known, and they may be prepared in a manner known.

For the preparation of the polar end group of the compound of the formula I easily obtainable polyfunctional compounds are used which are soluble in organic solvents or made soluble by means of a suitable protecting group during the synthesis. Suitable starting materials are 2,2-bis(hydroxymethyl)-propionic acid, pentaerythritol, glycerol, 1,2,5-pentanetriol and malonic acid. From some of the starting material chiral derivatives may be prepared which are used as staring material for the synthesis.

As examples of some of the intermediates to be prepared may be mentioned ditritylpentaerythritol, 1-trityl-glycerol, 1-trityl-1,2,5-pentanetriol and diethyl-and dimethylmalonate. From the diol intermediates the monoester and -ether may first be prepared using known methods. In a corresponding manner a second hydrocarbon chain may be introduced with an ester or ether bond. Into a malonic acid diester two similar or

different optionally substituted hydrocarbon groups may be introduced stepwise. After removal of the protecting group the functional groups of the polar head may be converted into other groups. for example a carboxylic group may be removed through decarboxylation. may be converted to an amide or reduced to an alcohol with borane.

For the preparation of the film aggregate according to the invention Langmuir-Blodgett film-forming technique is used. This technique is based on allowing a film-forming surface active compound orient itself as a monomolecular layer at the interface between two different phases, for example the interface between a liquid, such as water, glycerol etc, and a gas, such as air, argon etc, the hydrophilic (polar) part of the molecule orienting itself towards the liquid and the lipophilic part orienting itself in a direction away from the liquid.

In the original publication by Irwin Langmuir (Langmuir, I. (1917) J. Am. Chem. Soc. 39. 1848) the principles are disclosed according to which the organisation of the compounds into a monomolecular surface film takes place. The monograph by George Gaines (Gaines, G.L., Jr (1966) Insoluble Monolayers at Liquid-Gas Interfaces, Interscience Publishers, John Wiley and Sons Inc., New York 1966) deals extensively with different methods for the preparation of and research relating to monomolecular surface films.

In order to make the film aggregate according to the invention the film forming compound is dissolved in a suitable organic solvent or solvent mixture, for example in chloroform or cyclohexane, and is spread onto the surface of a liquid contained in a trough. By means of a boom which rests of top of the trough and which is in contact with the liquid surface, the available surface area of the liquid-gas-interface is restricted. the total area of the monomolecular surface film thus decreasing or increasing. By means of the boom it is thus possible to regulate the surface tension of the film, which is inversely proportional to the surface pressure of the film, and which is determined by measuring the force exerted on a sensor in the film by means of a sensitive balance.

From the film spread as a monomolecular layer, for example onto a water surface, the solvent evaporates rapidly. When a support forming the substrate is transported through the interface. preferably at constant speed, the film is deposited as a monomolecular layer onto the substrate, the lipophilic part towards the substrate when the support is transported through the interface in a direction from air to water, and the hydrophilic/polar part towards the substrate when the support is transported through the film in the opposite direction.

By transporting the support several times through the interface, substantially any number of film layers may be deposited onto the substrate. The film aggregate may also be prepared in such a manner that in the different film layers different compounds of the type described are used, whereby the invention makes it possible to prepare film aggregates tailor-made for each specific purpose. By using in the same film layer a mixture of different compounds the rheological properties of the film, for example its stiffness or flexibility, may be modified as desired.

As the supporting surface any material suitable for this purpose may be used, for example silicon, glass, quartz glass, metal or a suitable plastic. In case the support surface simultaneously serves as an electrode, a conduc ting material has to be used, such as a metal, or an inert material coated with a conducting layer. The support surface may also be pretreated as has been disclosed in our international patent application WO 86/04063.

The film aggregates obtained according to the invention may be used as such or the chains contained therein may be polymerized using double or triple bonds, for example by means of light, an electron beam or by heating, or alternatively they may in a suitable manner be attached to the support surface by means of groups suitable for this purpose, either as a whole film or only at specific parts depending on the intended use. The non-polymerized and/or non-bonded film areas may thereafter be removed if desired, in a suitable manner, for example by dissolving, whereby a film of the desired configuration is obtained. One usable application is for example in microlithographics, i.e. drawing on the film by means of a laser beam, UV-light, electron x-rays in order to polymerize and/or attach to the support surface, and thereafter removal of the untreated film areas.

The applicability of the afore defined compounds for the manufacture of multilayer LB-films is based on the formation of hydrogen bonds between the polar groups contained in two adjacent monomolecular layers. Depending on the manner of deposition, i.e. Y-type deposition, of the LB-film, the compound will orient itself in the film aggregate alternatively in a direction with the lipophilic end towards the support surface and alternatively in a direction away therefrom. Thus the polar heads will be situated opposite each other within the film aggregate and form hydrogen bonds between themselves according to the following formulas

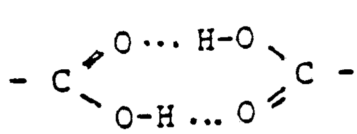

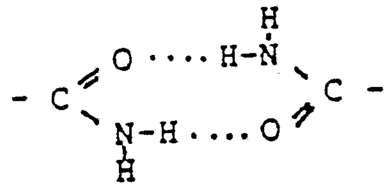

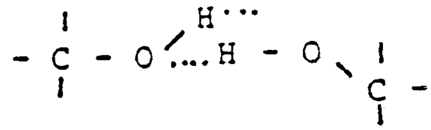

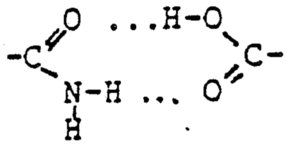

The formation of hydrogen bonds facilitates the film formation so that the transfer ratio remains good also when depositing the layers following the first layer. Furthermore, the presence of hydrogen bonds within the film to its own part stabilizes the film aggregate.

The following Examples 1 to 8 illustrate the preparation of some typical compounds to be used according to the invention and Example 9 illustrates the preparation of some film aggregates according to the invention using three different film forming compounds. Reference will be made herein to the accompanying Figure which is a series of three graphs showing the compression isotherms for the compounds of Example 9.

Example 1

3.07 g (= 7.0 mmoles) of tetradecylacid anhydride, 0.671 g (= 5.0 mmoles) of 2,2-bis(hydroxymethyl)-propionic acid and 13 ml of dichloromethane were mixed in a flask and into this was introduced within ½ hour 0.122 g (=1.0 mmoles) of 4-dimethylaminopyridine and 1.21 g (= 12.0 mmoles) of triethylamine dissolved in 13 ml of dichloromethane. The mixture was stirred for 1 hour at 25°C, washed with 2 x 10 ml of 0.5 M hydrochloric acid and water. The dichloromethane layer was dried on calcium sulphate, filtered and evaporated to dryness, yield approximately 3.5 g. From the raw product was isolated using chromatography two products, which were purified through crystallization.

A. 2,2-bis(hydroxymethyl)-propionic acid tetradecanoate m.p. 54-55°C $C_{19}H_{36}O_5$

B. 2,2-bis(hydroxymethyl)-propionic acid ditetradecanoate, m.p. 54-55°C $C_{33}H_{62}O_6$

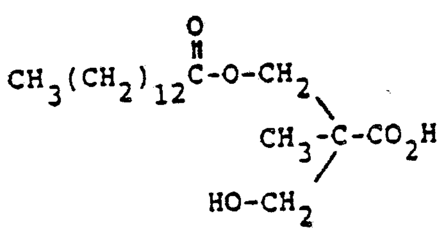

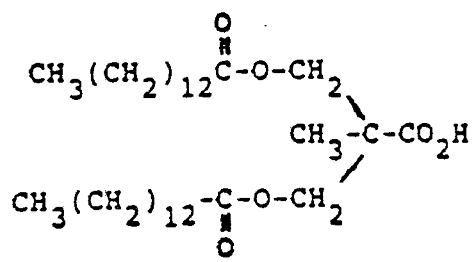

Example 2

1.77 g (=13.0 mmoles) of pentaerythritol and 25 ml of pyridine were heated and stirred. To the mixture were slowly added 6.14 g (= 14.0 mmoles) of tetradecylacid anhydride dissolved in 30 ml of pyridine, mixing was continued until the reaction had ended. The pyridine was removed by vacuum evaporation. From the raw product three products were isolated using chromatography, which products were purified by crystallization.

A. pentaerythritol tritetradecanoate m.p. 44°C $C_{47}H_{90}O_7$

B. pentaerythritol ditetradecanoate m.p. 55-58°C $C_{33}H_{64}O_5$

C. pentaerythritol tetradecanoate m.p. $C_{19}H_{38}O_5$

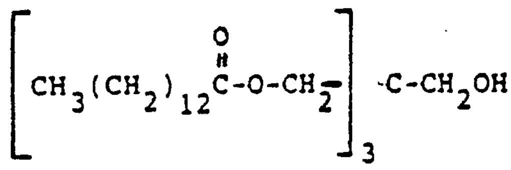

A

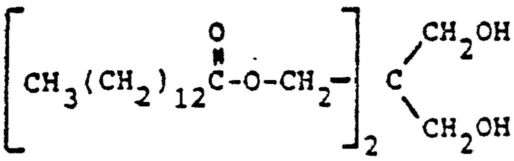

B

Example 3

1,3-distearoyl-glycerol

0.92 g of glycerol were dissolved into 10 ml of pyridine and into the mixture were added dropwise 6.05 g of stearic acid chloride. After one hour 20 ml of water were added to the mixture, the aqueous phase was removed and the paste dissolved into 40 ml of toluene. From the toluene solution the pyridine was extracted into 2M hydrochloric acid, washed with water, then with 0.5 M $NaHCO_3$-solution and 2 x with water. The toluene phase was dried over $Na_2SO_4$ and evaporated. It was purified chromatographically and crystallized. The melting point of the product was 76 to 77°C.

Example 4

2,2-dicetyl-1,3-propane-diol

487 mg of dicetyl malonic acid diethylester was dissolved into 4 ml of dry tetrahydrofuran and gradually 76 mg of litiumaluminiumhydrate were added. After one hour 40 ml of ethylacetate was gradually added, then 20 ml of 1M hydrochloric acid. The phases were separated, the ethylacetate phase was washed with 3 ml of warm water, then with 20 ml of 0.5 M $NaHCO_3$ and with water. After evaporation to dryness the product was crystallized from petrol ether. The melting point of the product was 65 to 66.5°C.

Example 5

Dicetylmalonic acid and its monoethylester

1.0 g of dicetylmalonic acid diethylester were dissolved in 20 ml of 94% ethanol and 265 mg of 85% KOH in 1.5 ml of water were added. The mixture was refluxed for 1 hour. 40 ml of ethyl acetate and 20 ml of 0.5 M hyd rochloric acid were added. The ethylacetate phase was further washed with 2 x 10 ml of water. The mixture was evaporated and purified on a column. Both products were crystallized. The monoethylester, m.p. 44°C and dicetylmalonic acid, m.p. 86°C were obtained.

Example 6

Dicetylacetic acid

Dicetylmalonic acid was heated appr. 0.5 hours at 180°C in an argon atmosphere, cooled and crystallized. The melting point of the product was 76 to 77°C.

Example 7

1,2-dipalmitoyl-sn-glycero-3-(succinate)

2.85 g of 1,2-dipalmitoylglycerol, 1 g of succinic anhydride, 122 mg of p-N,N-dimethylaminopyridine, 10 ml of dichloromethane and 10 ml of dry tetrahydrofuran were intoroduced into a flask. Thereafter 0.5 g of triethylamine were added. The mixture was slightly heated, whereby the materials dissolved. Mixing was continued for 1 hour. 30 ml of ethylacetate and 15 ml of 0,5M hydrochloric acid were added. The phases were separated and the ethylacetate phase was further washed with 2 x warm water. The ethylacetate phase was evaporated and crystallized to purity. The melting point of the product was 65°C.

## Example 8

1,2-dipalmitoyl-Sn-glycero-3-oxalate

Into a flask 1.27 g of oxalyl chloride were added and while stirring on an ice bath 2.85 g of 1,2-dipalmitoylglycerol were added dropwise dissolved in 10 ml of toluene into which had been added 2.5 ml of 2M triethylamine in toluene. The ice bath was removed and mixing was continued for 15 min. 10 ml of tetrahydrofuran were added and 1.6 g of $KHCO_3$ in 4 ml of water, stirred, and after 0.5 hours 40 ml of ethylacetate and 15 ml of 2M hydrochloric acid were added. The ethylacetate phase was still washed twice with water.

## Example 9

In order to make the films the compounds used, namely

a. 2,2-bis(hydroxymethyl)propionic amide ditetradecanoate

b. 0,0'-1,2-dicetylglycerol

c. 0,0'-1,2-dipalmitoyl-sn-glycerol were dissolved at a concentration of 1.00 mg/ml in chloroform. The film layers were prepared on the surface of purified water and deposited onto a quartz glass surface (37.5 x 12.5 mm) in an Langmuir-Blodgett-deposition system (apparatus KSV 2200 AFC/DFC) measuring the surface pressure with a platinum Wilhelmy-plate. Onto the subphase surface a monomolecular layer of the compound to be tested was spread. The surface pressure of the layer was adjusted to 40 mN/m, whereafter the substrate was transported through the film with the speed and direction indicated in the subsequent Table. During deposition the surface pressure was kept constant. The transfer ratio obtained for each layer is indicated in the Table. The deposition was carried out at room temperature.

From the Table is evident that the transfer ratio of the individual film layers is good, also for the layers subsequent to the first one. Into the Table only the values for the 20 first layers have been included althrough the transfer ratio remains good even for 60 deposited film layers.

The compression isotherms for the compounds a) to c) are shown in the appended drawing. The steep part of the curve indicates that the films are fluid, which means that they form suitable flexible monomolecular films onto the liquid surface which are suitable for film formation.

Compound a)

| Layer | Direction | Speed | Transfer ratio |
|---|---|---|---|
| 1 | down | 6.0 | 1.031 |
| 2 | up | 6.0 | 1.046 |
| 3 | down | 6.0 | 0.908 |
| 4 | up | 6.0 | 1.048 |
| 5 | down | 6.0 | 0.972 |
| 6 | up | 6.0 | 1.025 |
| 7 | down | 9.4 | 0.966 |
| 8 | up | 10.0 | 1.024 |
| 9 | down | 10.0 | 0.928 |
| 10 | up | 10.0 | 0.997 |
| 11 | down | 10.0 | 0.911 |
| 12 | up | 10.0 | 1.014 |
| 13 | down | 10.0 | 0.907 |
| 14 | up | 10.0 | 1.013 |
| 15 | down | 10.0 | 0.893 |
| 16 | up | 10.0 | 1.008 |
| 17 | down | 10.0 | 0.900 |
| 18 | up | 10.0 | 1.027 |
| 19 | down | 10.0 | 0.913 |
| 20 | up | 10.0 | 0.988 |

Compound b)

| Layer | Direction | Speed | Transfer ratio |
|---|---|---|---|
| 1 | down | 6.0 | 1.029 |
| 2 | up | 7.1 | 0.983 |
| 3 | down | 9.0 | 0.779 |
| 4 | up | 9.0 | 1.058 |
| 5 | down | 10.6 | 0.825 |
| 6 | up | 13.1 | 1.062 |
| 7 | down | 14.0 | 0.819 |
| 8 | up | 14.0 | 1.031 |
| 9 | down | 14.0 | 0.720 |
| 10 | up | 14.0 | 0.909 |
| 11 | down | 14.0 | 0.745 |
| 12 | up | 14.0 | 0.911 |
| 13 | down | 14.0 | 0.750 |
| 14 | up | 14.0 | 0.914 |
| 15 | down | 14.0 | 0.748 |
| 16 | up | 14.0 | 0.906 |
| 17 | down | 14.0 | 0.764 |
| 18 | up | 14.0 | 0.953 |
| 19 | down | 14.0 | 0.766 |
| 20 | up | 14.0 | 0.955 |

Compound c)

| Layer | Direction | Speed | Transfer ratio |
|---|---|---|---|
| 1 | down | 4.0 | 0.955 |
| 2 | up | 4.0 | 0.981 |
| 3 | down | 4.0 | 0.786 |
| 4 | up | 4.0 | 0.983 |
| 5 | down | 6.5 | 0.781 |
| 6 | up | 8.0 | 0.962 |
| 7 | down | 8.0 | 0.748 |
| 8 | up | 8.0 | 0.968 |
| 9 | down | 8.0 | 0.742 |
| 10 | up | 8.0 | 0.963 |
| 11 | down | 9.3 | 0.728 |
| 12 | up | 10.0 | 0.949 |
| 13 | down | 10.0 | 0.657 |
| 14 | up | 10.0 | 0.961 |
| 15 | down | 10.0 | 0.647 |
| 16 | up | 10.0 | 0.960 |
| 17 | down | 10.0 | 0.663 |
| 18 | up | 10.0 | 0.959 |
| 19 | down | 10.0 | 0.652 |
| 20 | up | 10.0 | 0.956 |

## Claims

1. A multilayered Langmuir-Blodgett film aggregate, which includes, on top of a solid support surface, a plurality of monomolecular layers of a compound of liquid crystal type containing 2 or 3 non-polar, long-chained, substantially aliphatic hydrocarbon groups in a molecular frame carrying at least one polar group capable of forming hydrogen bonds, the polar group being a hydroxy, amino, carboxy, or an amino group substituted with a substantially aliphatic hydrocarbon group, and in addition they may optionally contain a lower alkyl or lower alkoxycarbonyl group.

2. A multilayered film aggregate according to Claim 1, wherein the compound of liquid crystal type has the general formula



BAD ORIGINAL

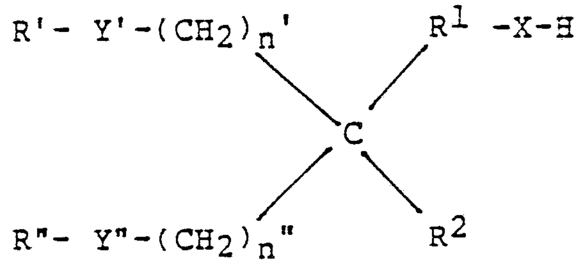

(I)

wherein R′ and R″ independently refer to a substantially aliphatic hydrocarbon group of approximately 8 to 30 carbon atoms, Y′ and Y″ independently refer to the group -O-, -C( = O)-O-, which over the oxygen atom is bound to the group $-(CH_2)_n$-or they refer to $-CH_2-$, n′ and n″ independently are zero or 1, $R^1$-X-H is a polar group wherein XH refers to hydroxy (OH), carboxyl (COOH), amino ($NH_2$), or an amino group substituted with a substantially aliphatic hydrocarbon group of not more than 30 carbon atoms, and $R^1$ is a direct bond. a carbonyl group -C( = O)-, lower alkylene or lower alkylene carboxyl lower alkylene. $R^2$ is hydrogen, lower alkyl or lower alkoxycarbonyl or has the meaning of $R^1$-X-H, or the meaning of R′-Y′-$(CH_2)_{n'}$-. provided that the compound (I) does not contain more than three lipophilic groups as defined.

3. A multilayered film aggregate according to Claim 2, wherein the substantially aliphatic hydrocarbon group R′ or R″ refers to a saturated or unsaturated straight or branched hydrocarbon group of advantageously 12 to 20 carbon atoms and which as a heteroatom may contain oxygen, nitrogen or sulphur, or as a part of the chain may contain covalently bound groups imparting the desired properties to the film provided that the substantially aliphatic nature of the group does not thereby change. or which contains groups polymerizing with an adjacent side chain or with the support surface.

4. A multilayered film aggregate according to Claim 1, wherein XH as the substituted amino group refers to lower alkyl substituted amino group.

5. A multilayered film aggregate according to any preceding claim, wherein in a film layer a mixture of two or more compounds of the formula I are used.

6. A multilayered film aggregate according to any preceding Claim, wherein, in the different film layers of the film aggregate,different compounds of the formula I are used.

7. An electronic component including a multilayered film aggregate according to any preceding Claim.

8. An optical memory including a multilayered film aggregate according to any one of Claims 1 to 6.

Compound a)

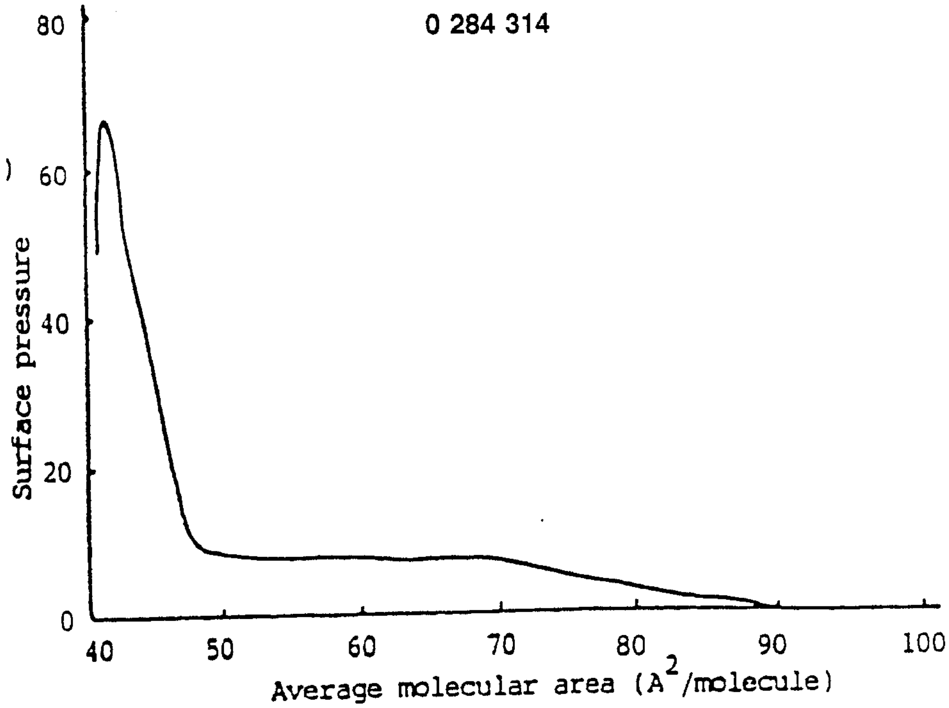


Compound b)

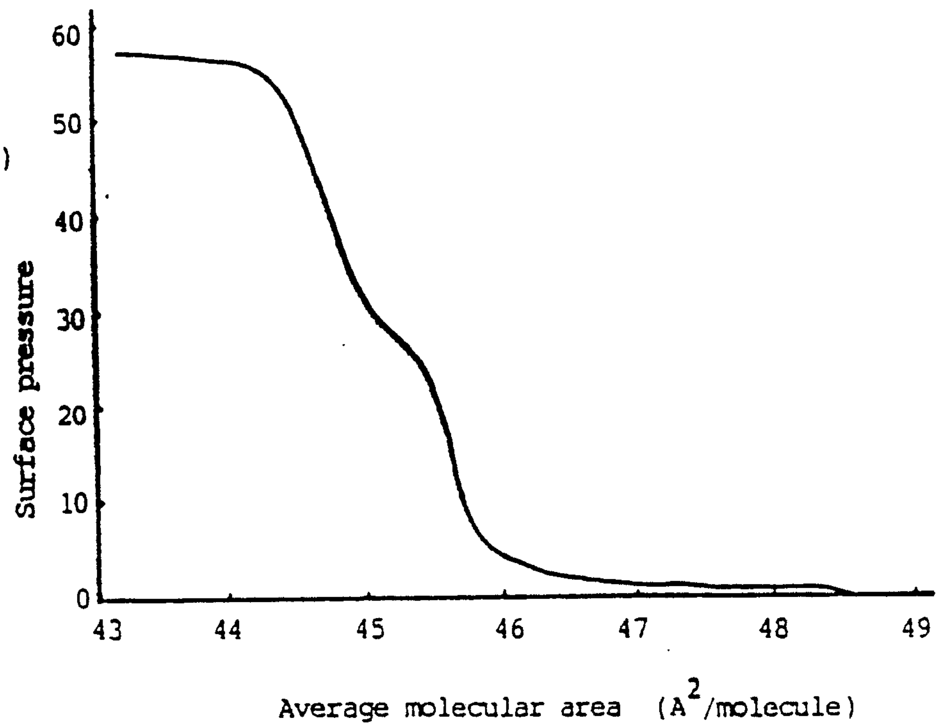


Compound c)

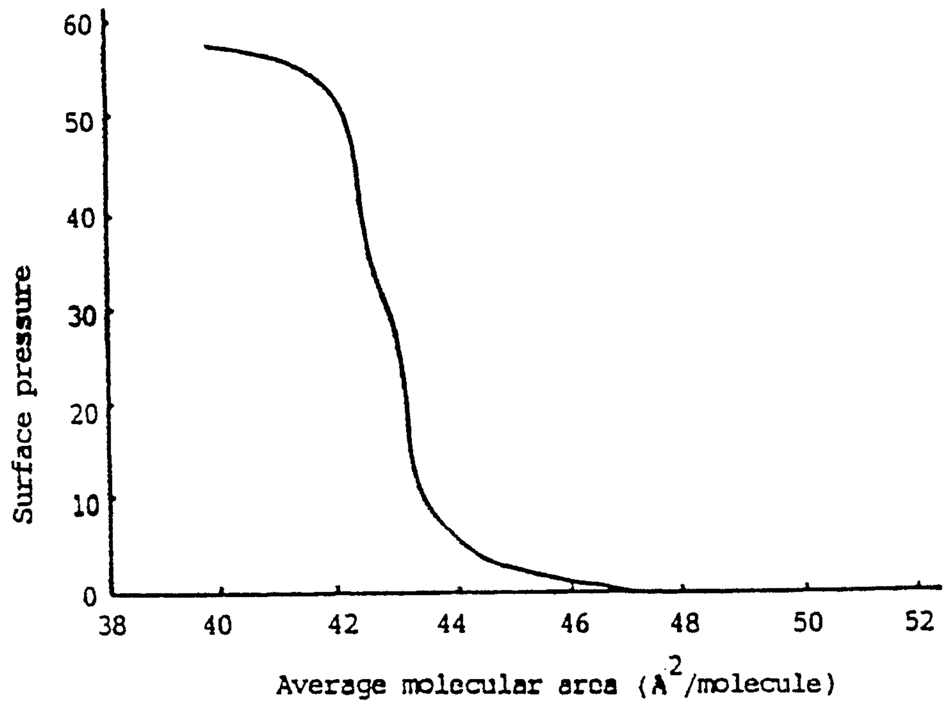

European Patent Office

# EUROPEAN SEARCH REPORT

Application number
EP 88 30 2424.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| E | US-A-4 659 177 (E.W. CHOE ET AL) | 1-7 | H 01 L 29/28<br>C 08 J 5/18<br>B 05 D 1/36 |
| E | EP-A-0 218 114 (KANEGAFUCHI KAGAKU KOGYO KABUSHIKI KAISHA) | 1-7 | |
| E | EP-A-0 232 829 (KANEGAFUCHI KAGAKU KOGYO KABUSHIKI KAISHA) | 1-7 | |
| X,A | WO-A1-87/00343 (KSV-CHEMICALS OY) | 1,2-7 | |
| X,A | WO-A1-87/00347 (THE SECRETARY OF STATE FOR DEFENCE IN HER BRITANIC MAYESTY´S GOVERNMENT OF UNITED KINGDOM AND NORTHERN IRELAND) | 1,2-7 | **TECHNICAL FIELDS SEARCHED (Int. Cl.4)** |
| X,A | GB-A-2 168 622 (THE GENERAL ELECTRIC COMPANY) | 1,2-7 | B 05 D<br>C 08 J<br>C 09 K<br>C 23 C<br>H 01 B<br>H 01 L |
| X,A | DE-A-2 544 672 (COMMISARIAT A L´ENERGIE ATOMIQUE) | 1,2-7 | |
| X,A | JOURNAL OF THE AMERICAN CHEM. SOCIETY, vol 101:18, August 29,1979, pages 5231-5234; Y OKAHATA ET AL: "Formation of stable monolayer membranes and related structures in -/- | 1,2-7 | |

The present search report has been drawn up for all claims

| Place of search | Date of completion of the search | Examiner |
|---|---|---|
| STOCKHOLM | 20-06-1988 | FORSLUND N. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent Office

# EUROPEAN SEARCH REPORT

Application number

EP 88 30 2424.2

| DOCUMENTS CONSIDERED TO BE RELEVANT | | | CLASSIFICATION OF THE APPLICATION (Int. Cl.4) |
|---|---|---|---|
| Category | Citation of document with indication, where appropriate, of relevant passages | Relevant to claim | |
| | dilute aqueous solution from two-headed ammonium amphiphiles"<br>----- | | H 01 L 29/28<br>C 08 J 5/18<br>B 05 D 1/36 |
| | | | TECHNICAL FIELDS SEARCHED (Int. Cl.4) |
| | | | B 05 D<br>C 08 J<br>C 09 K<br>C 23 C<br>H 01 B<br>H 01 L |